# EUROPEAN PATENT APPLICATION

(11) **EP 3 940 431 A1**
(43) Date of publication of application: **19.01.2022**
(21) Application number: 19914175.5
(22) Date of filing: 24.12.2019
(51) Int. Cl.: G01W 1/10

(54) **LIGHTNING ESTIMATION DEVICE, SYSTEM, AND METHOD**

(30) Priority: 12.03.2019 JP 2019044831
(71) Applicant: Kabushiki Kaisha Toshiba, Minato-ku Tokyo 105-0023 (JP); Toshiba Infrastructure Systems & Solutions Corporation, Kawasaki-shi, Kanagawa 212-0013 (JP)
(72) Inventor: KOBAYASHI, Tetsuya, Kawasaki-shi, Kanagawa 212-0013 (JP)
(74) Representative: Hoffmann Eitle
(86) International application number: PCT/JP2019/050551
(87) International publication number: WO 2020/183862

(57) **Abstract**

The lightning estimation apparatus includes a first acquisition unit, a second acquisition unit and a lightning analysis unit. The first acquisition unit acquires, from a radar apparatus, radar analysis data including a characteristic detection region obtained by analyzing a characteristic region of a meteorological phenomenon observed in a predetermined cycle. The second acquisition unit acquires lightning data including an observation result of a lightning strike point. The lightning analysis unit analyzes a spatial correlation between the characteristic detection region and the lightning strike point using integrated data in which the radar analysis data and the lightning data are associated in synchronization with each other.

## Description

Embodiments of the present invention relate to a lightning estimation apparatus, system, and method.

### BACKGROUND

In recent years, a weather radar (also called MP weather radar) called a dual polarization phased-array weather radar or multi-parameter phased-array weather radar has been developed.

The weather radar can quickly acquire the characteristics of meteorological phenomena such as cumulonimbus that causes heavy rain as three-dimensional observation data. For the observation of meteorological phenomena, it is important to observe lightning, because cumulonimbus not only causes heavy rain but also easily causes lightning (cloud discharge or ground discharge (lightning strike)). Lightning conditions change rapidly with time, so it is difficult to accurately evaluate the risk of lightning and avoid disasters such as lightning strikes in advance only with lightning data obtained by observing lightning.

### CITATION LIST

### PATENT LITERATURE

Patent Literature 1: Jpn. Pat. Appln. KOKAI Publication No. 2017-134062

### SUMMARY

### TECHNICAL PROBLEM

The present invention provides a lightning estimation apparatus that can accurately evaluate a lightning risk using observation data and lightning data obtained by a weather radar.

### SOLUTION TO PROBLEM

According to an aspect of the present invention, there is provided a lightning estimation apparatus comprising a first acquisition unit, a second acquisition unit and a lightning analysis unit. The first acquisition unit acquires, from a radar apparatus, radar analysis data including a characteristic detection region obtained by analyzing a characteristic region of a meteorological phenomenon observed in a predetermined cycle. The second acquisition unit acquires lightning data including an observation result of a lightning strike point. The lightning analysis unit analyzes a spatial correlation between the characteristic detection region and the lightning strike point using integrated data in which the radar analysis data and the lightning data are associated in synchronization with each other.

### BRIEF DESCRIPTION OF THE DRAWINGS

FIG. 1 is a block diagram illustrating the configuration of a system according to a first embodiment;
FIG. 2 is a block diagram illustrating the configuration of a weather radar apparatus according to the first embodiment;
FIG. 3 is a block diagram illustrating the configuration of a lightning estimation apparatus according to the first embodiment;
FIG. 4 is a block diagram illustrating the configuration of a lightning risk information processing apparatus according to the first embodiment;
FIG. 5 is a flowchart for explaining the operation of the weather radar apparatus according to the first embodiment;
FIG. 6 is a flowchart illustrating the operation of the lightning estimation apparatus according to the first embodiment;
FIG. 7 is a conceptual diagram for explaining lightning analysis data according to the first embodiment;
FIG. 8 is a diagram illustrating an example of a lightning risk determination result according to the first embodiment;
FIG. 9 is a block diagram illustrating the configuration of a system according to a second embodiment;
FIG. 10 is a block diagram illustrating the configuration of a system according to a third embodiment; and
FIG. 11 is a block diagram illustrating the configuration of a radar analysis optimization apparatus illustrated in FIG. 10.

### DETAILED DESCRIPTION

Embodiments will be described below with reference to the following drawings.

### [1] First Embodiment

### [System Configuration]

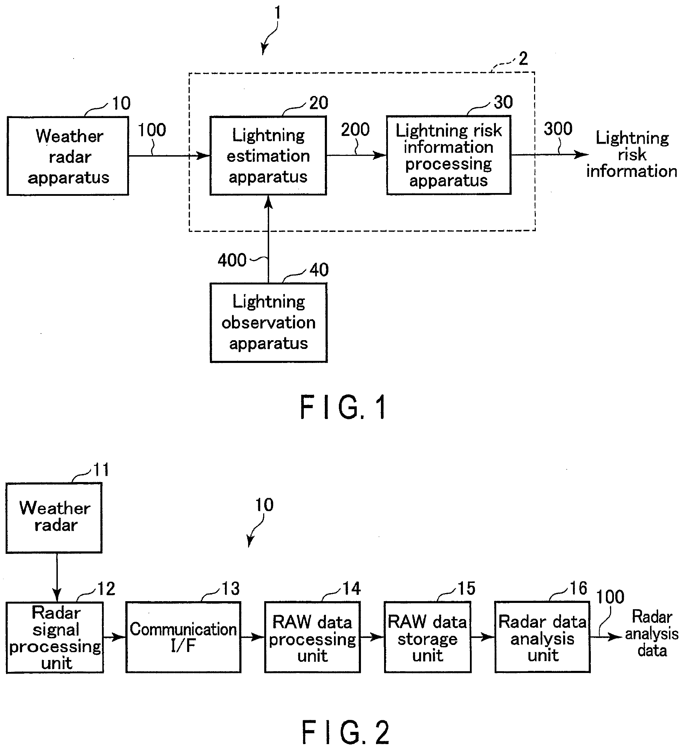

FIG. 1 is a block diagram illustrating the configuration of a system 1 of this embodiment. As illustrated in FIG. 1, the system 1 includes a weather radar apparatus 10, a lightning estimation apparatus 20, and a lightning risk information processing apparatus 30.

The weather radar apparatus 10 of this embodiment includes a dual polarization phased-array weather radar (hereinafter, this may be simply referred to as a weather radar) (see FIG. 2). The lightning estimation apparatus 20 acquires radar analysis data 100 based on observation data from the weather radar apparatus 10 and lightning data 400 from a lightning observation apparatus 40, and executes a lightning estimation process. The lightning risk information processing apparatus 30 acquires lightning analysis data 200 from the lightning estimation apparatus 20 and generates lightning risk information 300.

The lightning estimation apparatus 20 and the lightning risk information processing apparatus 30 are realized by a computer system 2 including software and hardware components. Further, the lightning observation apparatus 40 is included in an external system of the system 1 of this embodiment, and is realized by, for example, a server for a lightning observation service on a network. The computer system 2 receives the lightning data 400 from the lightning observation apparatus 40 via the network and inputs the data to the lightning estimation apparatus 20.

FIG. 2 is a block diagram illustrating the configuration of the weather radar apparatus 10. As illustrated in FIG. 2, the weather radar apparatus 10 includes a weather radar 11, a radar signal processing unit 12, a communication interface (I/F) 13, a RAW data processing unit 14, a RAW data storage unit 15, and a radar data analysis unit 16.

The weather radar 11 uses a phased-array antenna to observe the entire three-dimensional space, for example, in a cycle of 30 seconds by one turn. The radar signal processing unit 12 executes signal processing such as amplification processing and modulation processing on a radar signal (reflected wave signal) received by the weather radar 11. The communication I/F 13 transmits the radar signal processed by the radar signal processing unit 12 to the RAW data processing unit 14.

The RAW data processing unit 14 generates digital three-dimensional observation data (RAW data) from the radar signal from the radar signal processing unit 12. The RAW data storage unit 15 stores one cycle (for example, 30 seconds) of three-dimensional observation data generated by the RAW data processing unit 14. The radar data analysis unit 16 extracts one cycle of three-dimensional observation data from the RAW data storage unit 15, executes an analysis process, and outputs the radar analysis data 100 described later.

Further, the radar data analysis unit 16 may be configured to be able to receive the output result of a numerical weather prediction model, ground weather observation data, measurement data by a remote sensing meteorological instrument, and user information such as social networking service (SNS) from the Internet.

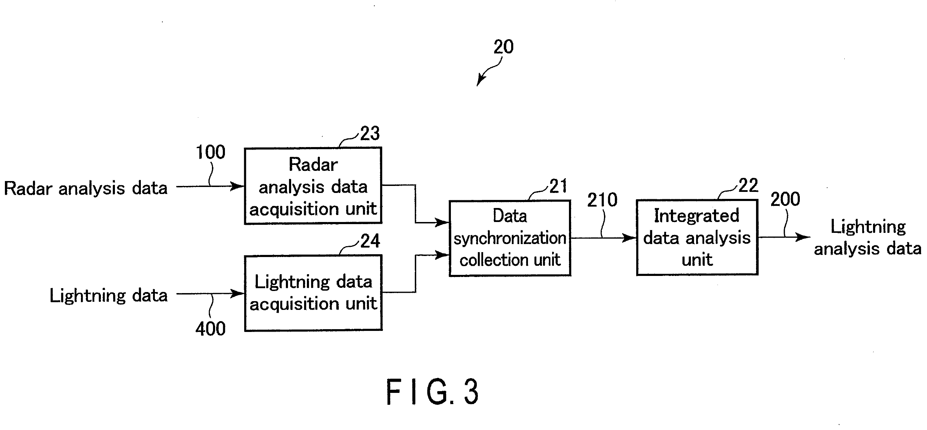

FIG. 3 is a block diagram illustrating the configuration of the lightning estimation apparatus 20. As illustrated in FIG. 3, the lightning estimation apparatus 20 includes a data synchronization collection unit 21, an integrated data analysis unit 22, a radar analysis data acquisition unit 23, and a lightning data acquisition unit 24.

The radar analysis data acquisition unit 23 acquires the radar analysis data 100 output from the radar data analysis unit 16. The lightning data acquisition unit 24 acquires the lightning data 400 from the lightning observation apparatus 40.

The data synchronization collection unit 21 receives the radar analysis data 100 acquired by the radar analysis data acquisition unit 23 and the lightning data 400 acquired by the lightning data acquisition unit 24, and collects the data in synchronization. That is, the data synchronization collection unit 21 synchronizes the radar analysis data 100 and the lightning data 400, and generates and outputs integrated data 210 associated with each other at the same time.

The integrated data analysis unit 22 receives the integrated data 210 from the data synchronization collection unit 21, executes an analysis process regarding lightning, and generates the lightning analysis data 200 described later. Further, the integrated data analysis unit 22 may include a learning function, accumulate past lightning analysis data 200, and use the learning function for generation processing of the lightning analysis data 200.

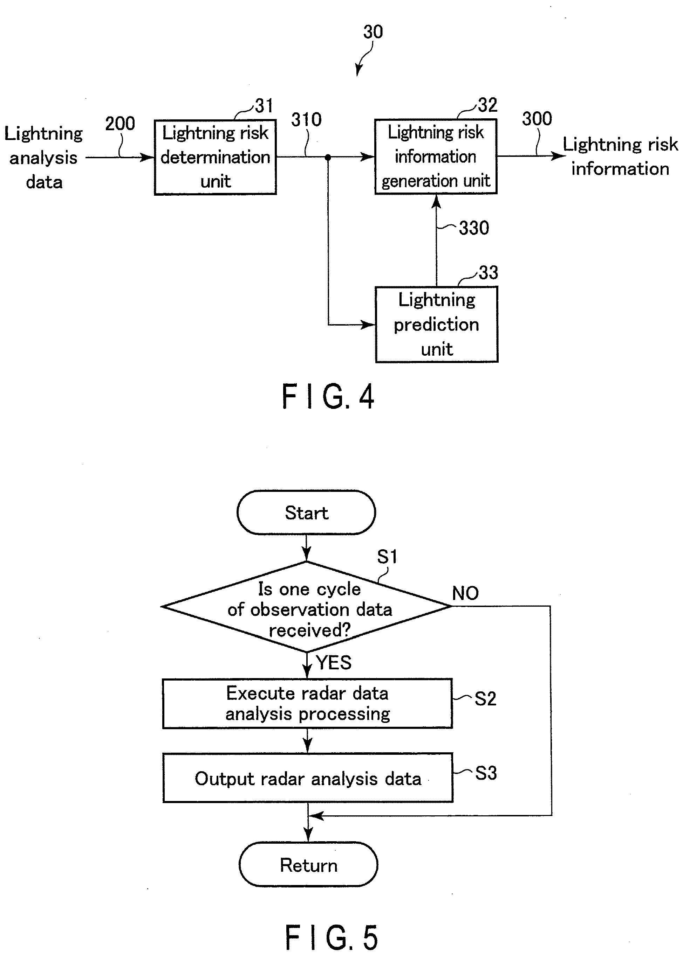

FIG. 4 is a block diagram illustrating the configuration of the lightning risk information processing apparatus 30. As illustrated in FIG. 4, the lightning risk information processing apparatus 30 includes a lightning risk determination unit 31, a lightning risk information generation unit 32, and a lightning prediction unit 33. The lightning risk determination unit 31 receives the lightning analysis data 200 from the integrated data analysis unit 22, determines a lightning risk described later based on the lightning analysis data 200, and outputs a determination result 310.

The lightning risk determination unit 31 may be configured to be able to receive the output result of another numerical weather prediction model, ground weather observation data, measurement data by a remote sensing meteorological instrument, and user information such as SNS from the Internet.

The lightning risk information generation unit 32 receives the lightning risk determination result 310 from the lightning risk determination unit 31 and generates the lightning risk information 300 described later. The lightning risk information 300 also includes information on risks such as disasters and power outages that take into account population and geographical conditions. Further, the lightning risk information generation unit 32 may be configured to be able to receive the output result of the numerical weather prediction model, ground weather observation data, measurement data by remote sensing meteorological instrument, land use data, topographic data, river basin data, geological data, route information, traffic information and the like.

Here, similarly to the lightning risk information generation unit 32, the lightning prediction unit 33 receives the lightning risk determination result 310 from the lightning risk determination unit 31, executes short-term lightning prediction up to several tens of minutes based on the determination result 310, and outputs a prediction result 330 to the lightning risk information generation unit 32. The lightning risk information generation unit 32 generates the lightning risk information 300 which also includes the prediction result 330 from the lightning prediction unit 33.

The computer system 2 may output the lightning risk information 300 to the terminal apparatus and display the lightning risk information 300 on a display screen of the terminal apparatus, for example. Alternatively, the computer system 2 may notify the lightning risk information 300 by e-mail via a network and transmit the information to a weather information providing server or the like.

### [System Processing]

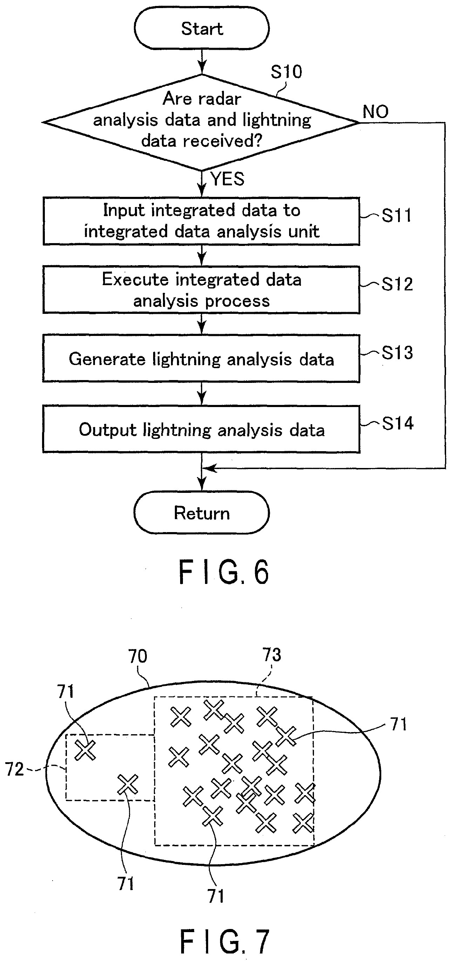

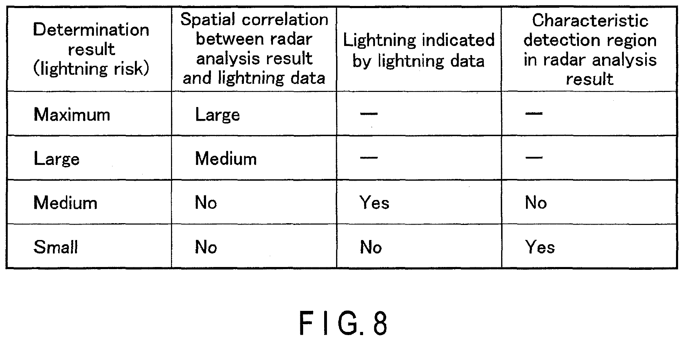

Hereinafter, the processing of the system according to this embodiment will be described with reference to FIGS. 5 to 8. FIG. 5 is a flowchart for explaining the operation of the radar data analysis unit 16 included in the weather radar apparatus 10. FIG. 6 is a flowchart for explaining the operation of the lightning estimation apparatus 20. FIG. 7 is a conceptual diagram illustrating lightning analysis data. FIG. 8 is a diagram illustrating an example of a lightning risk determination result.

As illustrated in FIG. 5, the radar data analysis unit 16 executes radar data analysis processing when the RAW data storage unit 15 receives and stores one cycle of three-dimensional observation data (YES in S1) (S2). Specifically, the radar data analysis unit 16 extracts one cycle of three-dimensional observation data from the RAW data storage unit 15 and executes the radar data analysis processing such as threshold processing for each polarization parameter and numerical conversion processing.

The radar data analysis unit 16 analyzes (detects) a characteristic region such as cumulonimbus in which lightning is likely to occur from the three-dimensional observation data, and generates the radar analysis data 100 indicating the characteristic region (S3). The characteristic region includes, for example, an echo top height, a precipitation core region in cumulonimbus, a hail existence probability, and a vertical direct current intensity in the cumulonimbus. The radar data analysis unit 16 outputs the characteristic region as two-dimensional or three-dimensional radar analysis data 100 at each observation cycle (for example, 30 seconds) of the weather radar 11 (S3).

Next, as illustrated in FIG. 6, in the lightning estimation apparatus 20, the data synchronization collection unit 21 receives the radar analysis data 100 from the radar data analysis unit 16 and the lightning data 400 from the lightning observation apparatus 40, and collects the data in synchronization (YES in S10). The data synchronization collection unit 21 synchronizes the radar analysis data 100 and the lightning data 400 and outputs the data to the integrated data analysis unit 22 as the integrated data 210 associated with each other at the same time (S11).

The integrated data analysis unit 22 receives the integrated data 210 from the data synchronization collection unit 21 and executes an analysis process regarding lightning (S12). Specifically, the integrated data analysis unit 22 analyzes the spatial correlation between a characteristic detection region in which the characteristic region of cumulonimbus obtained from the radar analysis data 100 is detected and the lightning strike point obtained from the lightning data 400, generates the analysis result as the lightning analysis data 200 (S13). Here, the lightning data 400 includes position information indicating the point of lightning strike. The characteristic detection region indicates a region where cumulonimbus is generated, that is, a region where lightning is likely to occur.

FIG. 7 is the conceptual diagram illustrating the lightning analysis data. As illustrated in FIG. 7, a characteristic detection region 70 of cumulonimbus can be acquired as a two-dimensional plane region based on the radar analysis data 100. The integrated data analysis unit 22 calculates a spatial correlation in the characteristic detection region 70 based on the density of the lightning strike points 71 obtained from the lightning data 400.

That is, in the characteristic detection region 70, a region 73 where a high density lightning strike point 71 is observed is defined as a region having a high spatial correlation. On the other hand, a region 72 having a sparse density lightning strike point 71 is defined as a region having a small spatial correlation. The regions illustrating these spatial correlations may be defined as a rectangular region, a concentric region, or a region surrounded by isopleths represented by continuous numerical values of 0 to 100. Further, in the characteristic detection region 70, a region which is not defined by the analysis result of the spatial correlation may be defined as a region having no spatial correlation.

The integrated data analysis unit 22 outputs the lightning analysis data 200 including the analysis result indicating the region 72 having a relatively small spatial correlation and the region 73 having a relatively large spatial correlation in the cumulonimbus characteristic detection region 70 (S14). The region 72 having a relatively small spatial correlation is a region where the frequency of lightning is actually small. On the other hand, the region 73 having a relatively large spatial correlation is a region where there is a high possibility of lightning and lightning actually occurs frequently.

The integrated data analysis unit 22 may be configured to accumulate the integrated data 210 and the lightning analysis data 200 over a long period of time, and generate the lightning analysis data 200, for example, only from the radar analysis data using the machine learning function and the deep learning function with the accumulation data.

The lightning risk information processing apparatus 30 includes the lightning risk determination unit 31, the lightning risk information generation unit 32, and the lightning prediction unit 33. FIG. 8 is a diagram illustrating an example of a lightning risk determination result 310 by the lightning risk determination unit 31.

The lightning risk determination unit 31 receives the lightning analysis data 200 from the integrated data analysis unit 22 and outputs a lightning risk determination result 310 as illustrated in FIG. 8 based on the lightning analysis data 200. Here, the lightning analysis data 200 includes an analysis result of cumulonimbus characteristic detection region, a lightning strike point (lightning strike position), and a spatial correlation degree.

As illustrated in FIG. 8, the lightning risk determination unit 31 outputs the determination result 310 that is determined in four stages (maximum, large, medium, small) as a lightning risk, for example. In the determination result 310, the lightning risk is determined to be maximum in the region in which the spatial correlation is relatively large in the characteristic detection region. In addition, the lightning risk is determined to be large in a region where the spatial correlation is relatively medium. Further, in the characteristic detection region, the lightning risk is determined to be medium in the region where there is no spatial correlation and the lightning strike point based on the lightning data exists. Regarding the region where the lightning strike point does not exist, the lightning risk is determined to be small if it is within the characteristic detection region.

The lightning prediction unit 33 receives the lightning risk determination result 310 from the lightning risk determination unit 31 and executes a short-term lightning prediction process up to several tens of minutes based on the determination result 310. The lightning prediction unit 33 calculates the prediction result 330 of the lightning for the region of the lightning risk to be noticed by a known method such as a two-dimensional advection model. Further, since the lightning prediction unit 33 can receive data having a high time resolution, the lightning prediction unit 33 can calculate the prediction result 330 having a high time resolution in which the time step of prediction is from several tens of seconds to several minutes.

Further, the lightning risk information generation unit 32 generates the lightning risk information 300 indicating the level of lightning risk for a region based on the characteristic detection region using the lightning risk determination result 310 from the lightning risk determination unit 31 and the prediction result 330 from the lightning prediction unit 33. The lightning risk information 300 may include information on risks such as disasters and power outages weighted by population and geographical conditions. The geographical conditions include, for example, the vicinity of a venue of an event or the like, which may be weighted.

Further, the lightning risk information generation unit 32 may be configured to accumulate the prediction result 330 for a certain period, compare the past prediction result 330 with the current lightning risk determination result 310, and generate the lightning risk information 300 with high accuracy based on this comparison result. Specifically, in a case where the lightning risk information generation unit 32 determines that the lightning risk is high from the past prediction result 330, and the current lightning risk determination result is also high, the lightning risk information generation unit 32 may provide the information as information having a higher risk than the current lightning risk.

Further, the lightning risk information generation unit 32 may generate the lightning risk information 300 as numerical information, or may generate the lightning risk information 300 using a probability prediction model or a learning model.

As described above, according to this embodiment, the weather radar 11 can be used to acquire the radar analysis data indicating the characteristic detection region of cumulonimbus in which lightning is likely to occur, for example, from the spatiotemporally continuous radar data observed at a period of 30 seconds. This radar analysis data and the lightning data with a high time resolution are synchronized, and integrated data that is associated at the same time is used, so that the spatial correlation between the characteristic detection region of cumulonimbus and the lightning strike point obtained from the lightning data can be analyzed. Specifically, the lightning estimation apparatus 20 of this embodiment outputs lightning analysis data including the spatial correlation, the characteristic detection region of cumulonimbus, and the analysis result of the lightning strike point (lightning strike position).

The spatial correlation included in the lightning analysis data is information that can determine the lightning risk within the characteristic detection region. In this embodiment, the lightning risk is determined in four stages (see FIG. 8). Therefore, the lightning risk information processing apparatus 30 of this embodiment can output the lightning risk information including the determination result of the lightning risk in real time and with high accuracy using the lightning analysis data calculated by the lightning estimation apparatus 20.

Further, the lightning risk information processing apparatus 30 combines population information, land information, route information, traffic information, and the like in addition to the determination result of the lightning risk and the short-term lightning prediction that are observation results, so that risk information for human and economic lightning disasters can be provided with high accuracy and speed. For example, it is possible to promptly provide risk information by identifying a golf course or the like that has a high risk of lightning and a high risk of human lightning disaster. Thereby, the computer system 2 including the lightning risk information processing apparatus 30 of this embodiment notifies the general public of the risk information for the lightning disaster, for example, by e-mail via a network, and also it is possible to build a disaster prevention system that can be provided to the weather information providing server.

### [2] Second Embodiment

The second embodiment is an example for providing the user with information about lightning.

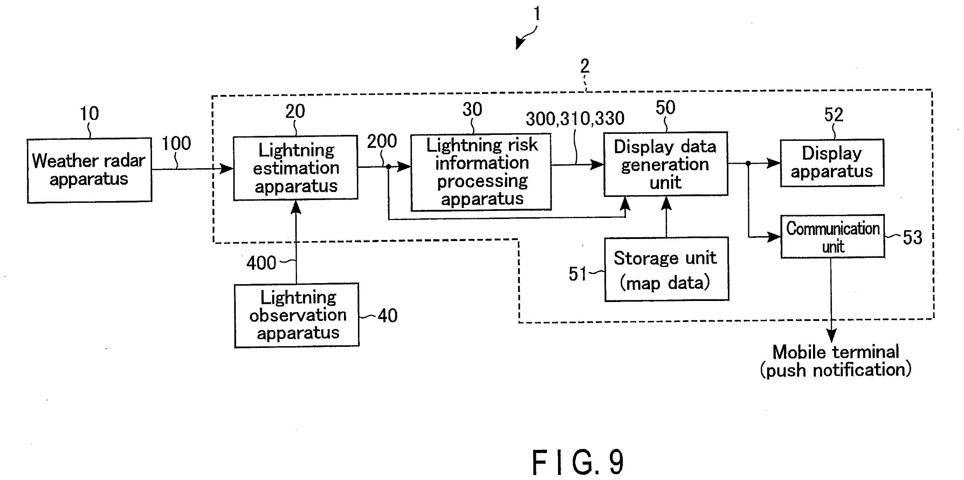

FIG. 9 is a block diagram illustrating the configuration of the system 1 according to the second embodiment. The system 1 further includes a display data generation unit 50, a storage unit 51, a display apparatus 52, and a communication unit 53. The configurations of the lightning estimation apparatus 20 and the lightning risk information processing apparatus 30 are the same as those in the first embodiment.

The storage unit 51 stores map data.

The display data generation unit 50 receives the lightning analysis data 200 from the lightning estimation apparatus 20, receives the lightning risk information 300, a prediction result (lightning prediction result) 330 of lightning, and a determination result (lightning risk determination result) 310 of a lightning risk from the lightning risk information processing apparatus 30, and receives map data from the storage unit 51. The display data generation unit 50 generates display data using the plurality of pieces of the received information.

That is, the display data generation unit 50 digitizes the information (spatial correlation information) about the spatial correlation included in the lightning analysis data 200. The display data generation unit 50 displays the region determined to be the lightning risk on a map, and also displays the digitized spatial correlation information as the "determination reliability of lightning risk" on the region in a superimposed manner. For example, in the digitized spatial correlation information, the spatial correlation is represented as a numerical value of 0 to 100, for example, and this numerical value is displayed as information that is visually recognizable by color gradation.

The determination reliability of lightning risk may be displayed by being superimposed on the lightning risk information 300. Further, the determination reliability of lightning risk may be displayed by switching with a button or the like.

In addition, the lightning prediction result 330 may also be digitized as spatial correlation information and displayed on the map as the prediction reliability in superimposition with the lightning prediction result 330.

The display apparatus 52 includes a screen (display), and displays the display data transmitted from the display data generation unit 50 on the screen.

### (Other Embodiments)

The display data generation unit 50 sends a push notification regarding lightning information to a user's mobile terminal at a certain point. The communication unit 53 communicates with an external apparatus (including mobile terminal) via a network.

Specifically, the display data generation unit 50 determines a threshold by using lightning information immediately above the point where the user is or within a specific range. The notification threshold is set differently for each user and for each place where the user is. Then, the display data generation unit 50 notifies the user, who has been determined to be required to be notified by the threshold determination, of the lightning information. As a result, it is possible to provide optimum lightning information for each user.

### [3] Third Embodiment

In the third embodiment, machine learning or deep learning is used to optimize the lightning risk determination.

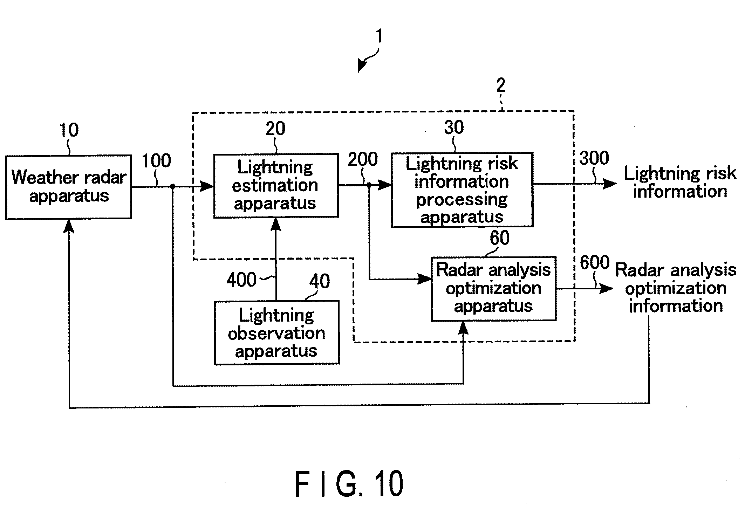

FIG. 10 is a block diagram illustrating the configuration of the system 1 according to the third embodiment. The system 1 further includes a radar analysis optimization apparatus 60.

The radar analysis optimization apparatus 60 receives the radar analysis data 100 from the weather radar apparatus 10 and the lightning analysis data 200 from the lightning estimation apparatus 20. The radar analysis optimization apparatus 60 includes a machine learning function or a deep learning function. The radar analysis optimization apparatus 60 generates radar analysis optimization information 600. The radar analysis optimization information 600 is transmitted to the radar data analysis unit 16.

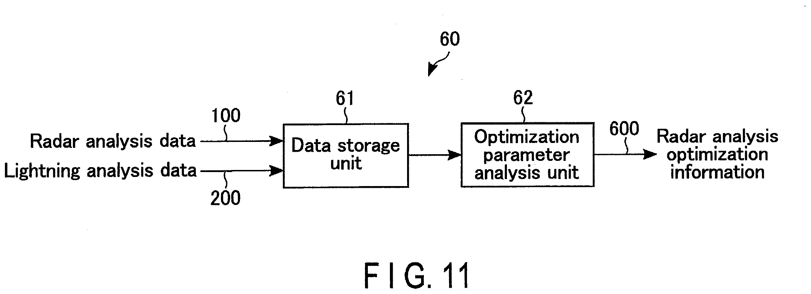

FIG. 11 is a block diagram illustrating the configuration of the radar analysis optimization apparatus 60 illustrated in FIG. 10. The radar analysis optimization apparatus 60 includes a data storage unit 61 and an optimization parameter analysis unit 62.

The data storage unit 61 stores the radar analysis data 100 from the weather radar apparatus 10 and the lightning analysis data 200 from the lightning estimation apparatus 20.

The optimization parameter analysis unit 62 performs the machine learning or deep learning using the plurality of radar analysis data 100 and the plurality of lightning analysis data 200 stored in the data storage unit 61. The optimization parameter analysis unit 62 optimizes the analysis parameter of the characteristic detection region in the radar data analysis unit 16 included in a radar apparatus 11 for the determination of lightning risk.

That is, the optimization parameter analysis unit 62 learns a region having a high spatial correlation (a region where lightning is actually occurring) in the characteristic detection region, and calculates an optimization parameter as the learning result. The optimization parameter is determined so that the deviation between the characteristic detection region detected by the radar data analysis unit 16 and the region having a high spatial correlation is reduced. The radar data analysis unit 16 analyzes the characteristic detection region using the optimization parameter included in the radar analysis optimization information 600. As a result, the radar data analysis unit 16 can extract a region having a high spatial correlation (a region in which thunder is actually occurring) as a characteristic detection region with higher accuracy.

The timing for transmitting the radar analysis optimization information 600 generated by the radar analysis optimization apparatus 60 to the radar data analysis unit 16 in the weather radar apparatus 10 can be set arbitrarily. Basically, it is desirable to feed back to the radar data analysis unit 16 after learning progresses in the radar analysis optimization apparatus 60 and a learning result is obtained. Further, for example, the radar analysis optimization information 600 may be transmitted from the radar analysis optimization apparatus 60 to the radar data analysis unit 16 at the timing designated by the user.

In addition, in the above embodiments, although it demonstrated using the dual polarization phased-array weather radar as an example, the invention is not limited to this. The above embodiments can be applied to weather radars other than the dual polarization phased-array weather radar.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

## Claims

1. A lightning estimation apparatus, comprising:
a first acquisition unit that acquires, from a radar apparatus, radar analysis data including a characteristic detection region obtained by analyzing a characteristic region of a meteorological phenomenon observed in a predetermined cycle;
a second acquisition unit that acquires lightning data including an observation result of a lightning strike point; and
a lightning analysis unit that analyzes a spatial correlation between the characteristic detection region and the lightning strike point using integrated data in which the radar analysis data and the lightning data are associated in synchronization with each other.

2. The lightning estimation apparatus according to claim 1,
wherein the radar apparatus includes a dual polarization phased-array weather radar.

3. The lightning estimation apparatus according to claim 1,
wherein the characteristic detection region includes a generation region of cumulonimbus.

4. The lightning estimation apparatus according to claim 1,
wherein the lightning analysis unit outputs lightning analysis data including the spatial correlation as information for determining a lightning risk.

5. The lightning estimation apparatus according to claim 1,
wherein, in the characteristic detection region, a region in which the lightning strike point of relatively high density is observed is defined as a region in which the spatial correlation is large and a lightning risk is large.

6. The lightning estimation apparatus according to claim 1, further comprising:
a collecting unit that synchronizes the radar analysis data and the lightning data and collects the integrated data that are associated with each other at the same time.

7. A system, comprising:
a lightning estimation apparatus according to claim 1;
a radar apparatus that includes a dual polarization phased-array weather radar; and
a lightning risk information processing apparatus,
wherein the lightning risk information processing apparatus uses lightning analysis data obtained from the lightning estimation apparatus to generate lightning risk information including a determination result of a lightning risk in the characteristic detection region based on a spatial correlation between the characteristic detection region and the lightning strike point included in the lightning analysis data.

8. The system according to claim 7,
wherein, as the determination result of the lightning risk in the characteristic detection region, the lightning risk information processing apparatus determines the lightning risk to be maximum for a region having a relatively large spatial correlation in the characteristic detection region, determines the lightning risk to be large for a region having a relatively medium spatial correlation, determines the lightning risk to be medium for a region where there is no spatial correlation and the lightning strike point exists, and determines the lightning risk to be small for a region where there is no spatial correlation and the lightning strike point does not exist.

9. The system according to claim 7, further comprising:
a generation unit that generates display data which includes map information and information obtained by digitizing the spatial correlation; and
a display apparatus that displays the display data on a screen.

10. A method of analyzing a lightning phenomenon using a radar apparatus, comprising:
acquiring, from the radar apparatus, radar analysis data including a characteristic detection region obtained by analyzing a characteristic region of a meteorological phenomenon observed in a predetermined cycle;
acquiring lightning data including an observation result of a lightning strike point; and
analyzing a spatial correlation between the characteristic region and the lightning strike point using integrated data in which the radar analysis data and the lightning data are associated in synchronization with each other.

11. The method according to claim 10,
wherein lightning risk information including a determination result of lightning risk in the characteristic detection region is generated based on a spatial correlation between the characteristic detection region and the lightning strike point.

12. The method according to claim 11,
wherein, as the determination result of the lightning risk in the characteristic detection region, the lightning risk is determined to be maximum for a region having a relatively large spatial correlation in the characteristic detection region, the lightning risk is determined to be large for a region having a relatively medium spatial correlation, the lightning risk is determined to be medium for a region where there is no spatial correlation and the lightning strike point exists, and the lightning risk is determined to be small for a region where there is no spatial correlation and the lightning strike point does not exist.
